# EUROPEAN PATENT APPLICATION

(11) **EP 0 766 322 A2**
(43) Date of publication of application: **02.04.1997**
(21) Application number: 96115465.5
(22) Date of filing: 26.09.1996
(51) Int. Cl.: H01L 31/075, H01L 31/0392

(54) **Photovoltaic device with an improved light reflecting layer and method for manufacturing it**

(30) Priority: 28.09.1995 JP 250712/95; 28.09.1995 JP 250713/95
(71) Applicant: CANON KABUSHIKI KAISHA, Tokyo (JP)
(72) Inventor: Arao, Kozo, Tokyo (JP); Nakagawa, Katsumi, Tokyo (JP); Iwasaki, Yukiko, Tokyo (JP)
(74) Representative: Pellmann, Hans-Bernd, Dipl.-Ing.

(57) **Abstract**

A method for manufacturing a photovoltaic device comprising a metal layer, a first transparent conductive layer, a semiconductor layer and a second transparent conductive layer stacked on a substrate comprising iron in sequence, comprises the steps of forming the metal layer by deposition of a material constituting the metal layer from a solution and forming the first transparent conductive layer by deposition of a material constituting the first transparent conductive layer from a solution.

## Description

### Background of the Invention

### Field of the Invention

The present invention relates to a method for manufacturing a photovoltaic device, and more specifically, to a method for manufacturing a photovoltaic device composed of a non-monocrystalline semiconductor material containing silicon or germanium atoms, e.g., hydrogenated amorphous silicon, hydrogenated amorphous silicon germanium, hydrogenated amorphous silicon carbide, microcrystalline silicon, polycrystalline silicon or the like, with an improved light reflecting layer.

### Related Background Art

At present, the energy that we mankind are consuming depends upon the steam power generation using a fossil fuel such as petroleum and coal, and the atomic power generation to a large extent. However, it involves many problems for us to wholly rely in future on the fossil fuel that brings about the warming of the earth on account of carbon dioxide generated at the use thereof, or on the atomic power that is not said to accompany no danger of radiation injury not only in an unforeseen disaster but also even during a normal operation. Thus, attention is focused on the solar power generation using a solar cell exerting an extremely small influence on the global environment and its further spread is expected.

For such a solar cell, a photovoltaic device has been employed which is composed of hydrogenated amorphous silicon, hydrogenated amorphous silicon germanium, hydrogenated amorphous silicon carbide, microcrystalline silicon, polycrystaline silicon and so on. In addition, to improve the light collectivity in long wavelength region, a reflecting layer is preferably provided on the back side in these devices. Such a reflecting layer is desired to indicate an effective reflecting characteristic at a wavelength region of small absorption near the band edge of a semiconductor material, i.e., in a region of 800 nm to 1200 nm. As those fully satisfying this condition, for example, a metal layer comprising gold, silver, copper or the like is mentioned. In addition, to prevent the deterioration of characteristics due to a shunt pass, the technique of providing a layer comprising a light transmissive material having an electrical conductivity, i.e., transparent conductive material between the metal layer and a semiconductor layer is utilized. Generally the metal layer and the transparent conductive layer are formed, for example, on a base member, for example, by the vacuum deposition method or the sputtering method. The photovoltaic device comprising such a metal layer or transparent conductive layer has an improved Jsc (Shunt Current: a current obtained by collecting photocarrier generated by solar rays to an electrode by the inner electric field during the short circuit of a solar cell and outputting from the electrode, which increases with more effective use of solar energy) of 1 mA or more.

However, the aforesaid photovoltaic device has the following problems.
(1) A metal layer or a transparent conductive layer formed by the vacuum deposition method or the sputtering method was sufficient in electric and optical characteristics but had a problem of being easily peeled off, related to the close adhesion. In uses of generating the electricity with a photovoltaic device provided outdoors for a long period, uneasiness remains for a long-term reliability.
(2) To form a metal layer or a transparent conductive layer of the aforesaid photovoltaic device, the vacuum device may need a high repayment cost, so that the utilization efficiency of a material is insufficient. This extremely raises the cost of a photovoltaic device using the aforesaid technique, which is a large hindrance factor in the industrial application of a solar cell. To forward a future electric generation system from the non-polluting standpoint as well as for the aforesaid reason, the cost reduction of a photovoltaic device is eagerly desired.

### SUMMARY OF THE INVENTION

An object of the present invention which has been made in consideration of the above circumstances is to provide a method for enabling a metal layer and a transparent layer excellent in adhesion with the layer in contact therewith to be formed inexpensively and easily and manufacturing a high performance photovoltaic device comprising these layers.

The above-mentioned object of the present invention is achieved by a method for manufacturing a photovoltaic device comprising a metal layer, a first transparent conductive layer, a semiconductor layer and a second transparent conductive layer stacked on a substrate containing at least iron in sequence, comprising the steps of:
forming the metal layer by deposition of a material constituting the metal layer from a solution; and
forming the first transparent conductive layer by deposition of a material constituting the first transparent conductive layer from another solution.

In addition, according to the present invention, a photovoltaic device, comprising a metal layer formed by plating, a first transparent conductive layer formed by plating, a semiconductor layer and a second transparent conductive layer stacked on a substrate containing at least iron in sequence, is provided.

### BRIEF DESCRIPTION OF THE DRAWINGS

Fig. 1 is a sectional view schematically showing one example of structure of a photovoltaic device manufactured according to the present invention;
Fig. 2 is a sectional view schematically showing another example of structure of a photovoltaic device manufactured according to the present invention;
Fig. 3 is a sectional view showing the outline of one example of apparatus for forming a metal layer or a transparent conductive layer on the substrate to be used in the present invention;
Fig. 4 is a sectional view showing the outline of one example of apparatus for continuously forming a metal layer or a transparent conductive layer on the substrate to be used in the present invention; and
Fig. 5 is a sectional view showing the outline of another example of apparatus for continuously forming a metal layer or a transparent conductive layer on the substrate to be used in the present invention.

### DETAILED DESCRIPTION OF THE PREFERRED EMBODIMENTS

The method of the present invention for manufacturing a photovoltaic device comprising a metal layer, a first transparent conductive layer, a semiconductor layer and a second transparent conductive layer stacked on an iron-containing substrate in sequence is characterized in that the metal layer and the transparent layer are formed by deposition of each material constituting the layer from a solution, respectively. In this manner, an expensive film forming apparatus by the vacuum deposition method or the sputtering method becomes unnecessary and the respective layers can be formed stably and easily at low cost in the manufacturing of a photovoltaic device, at the same time a high performance photovoltaic device can be obtained.

According to the present invention, the surface shape of the substrate may be made uneven preferably by etching the iron-containing substrate with an acidic solution. As a result, by forming a metal layer and a first transparent conductive layer on the substrate in sequence by the above method, an uneven structure is given to these layers. Accordingly, since the respective layers can confine the back reflective light within themselves, a further effective utilization of an incident light can be attained, thereby improving the characteristic of the photovoltaic device especially concerning the efficiency of light collection.

According to the present invention, in a photovoltaic device comprising such a metal layer formed from preferably copper, a near IR light effective as the back reflected light can be reflected on the metal layer without loss and a confinement effect is further promoted, thus bringing about an improvement in device characteristics.

In addition, in the present invention, the metal layer may be made in at least a two-layered structure comprising a first metal layer and a second metal layer stacked. In this case, preferably a layer comprising zinc and a layer comprising copper are formed as the first metal layer (preferably on the substrate side) and as the second metal layer (preferably on the semiconductor side), respectively. By the provision of such multilayer-structured metal layers, a photovoltaic device with excellent characteristics can be obtained in which an effective near IR light as the rear reflecting light can be reflected on the back reflecting layer without loss and the confinement effect of reflected light is further promoted.

According to the present invention, preferably zinc oxide is employed as the first transparent conductive layer. In a photovoltaic device comprising the first transparent conductive layer obtained in this manner, especially in the transparent conductive layer, transmittance to a near IR light effective as the reflected light is good, crystal grains having the order of the wavelength are formed and the scattered component of reflected rays can be greatly increased, so that an increase in the aforesaid J_{SC} of the device becomes possible.

A photovoltaic device according to the present invention is applied, for example, to a solar cell, a sensor, an image pickup device and so on, and further to uses in which, by the multistepped connection of devices in an array, a stable operation is required in outdoor environments for a long period of time, appropriately, for example, to a solar energy generation used for a house or an aggregate structure, or in a connection to a system.

Hereinafter, embodiments according to the present invention will be described in more detail.

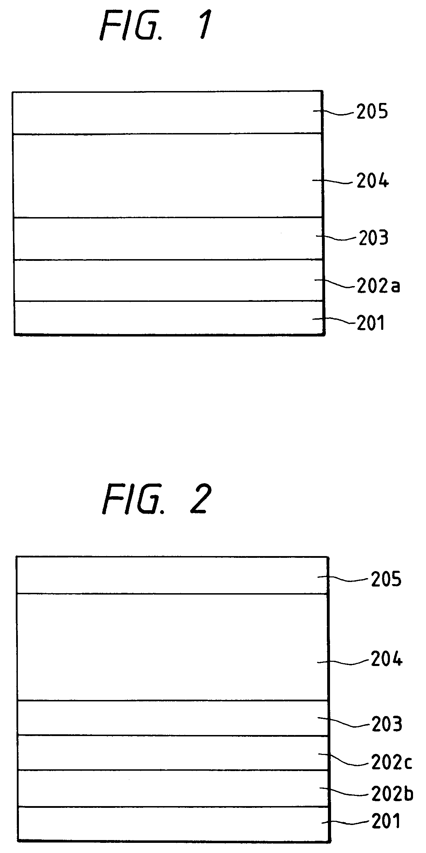

Fig. 1 shows one example of a photovoltaic device according to the present invention. The device shown in Fig. 1 has a structure comprising an iron-containing substrate 201, a metal layer 202a, a first transparent conductive layer 203 in contact with the metal layer 202a, a semiconductor layer 204 functioning to convert optical energy into electric energy, and a second transparent conductive layer 205 stacked in sequence.

Fig. 2 shows another example of a photovoltaic device according to the present invention. The device shown in Fig. 2 has a structure comprising an iron-containing substrate 201, a first metal layer 202b, a second metal layer 202c, a first transparent conductive layer 203 in contact with the second metal layer 202c, a semiconductor layer 204 functioning to convert optical energy into electric energy, and a second transparent conductive layer 205 stacked in sequence.

Next, methods according to the present invention will be described on the basis of the respective members constituting each of the above-mentioned photovoltaic devices as shown, for example, in Fig. 1 or 2.

First of all, an iron-containing substrate (e.g., 201 shown in Figs. 1 and 2) is prepared. As the iron-containing substrate (e.g., a layer 201 in Fig. 1 or 2), preferably a sheet-shaped or foil-shaped substrate with the surface etched with an acidic solution such as hydrofluoric acid or nitric acid, is employed. And, as mentioned later, a substrate may be made into the shape of roll for the formation of upper layers by a continuous treatment. To prevent the occurrence of rust at the edge face, a nickel- or chrome-introduced stainless steel may be employed as a substrate material. The substrate is etched preferably with an acidic solution as mentioned above to form unevenness on the order of 1 µm. In this way, it becomes possible to confine the back reflected rays as mentioned above.

An iron-containing substrate is determined from the strength as a substrate, the bending resistance, the edge anticorrosion, or the like, but preferably contains carbon, silicon, magnesium, chromium, nickel or the like. Especially, ferrite group stainless steels containing nickel, martensite group stainless steels containing nickel and chrome, and such other stainless steels are advantageous in a simple treatment because of no need for anticorrosive treatment.

In addition, from the standpoint of cost, a cold roll steel sheet maybe used. As for the shape, not only a steel sheet rolled in a roll but a foil or sheet may be also used.

Preferably on the substrate, a metal layer (e.g., 202a shown in Fig. 1 or 202b and 202c shown in Fig. 2) is formed by deposition of a metal material for such a layer from a solution, preferably by plating. When the metal layer is a single layer, i.e., as the layer 202a shown in Fig. 1, the metal layer is formed by soaking the substrate into an aqueous solution containing copper ions, pyrophosphorate ions and nitrate ions and copper-plating the substrate taken as the cathode.

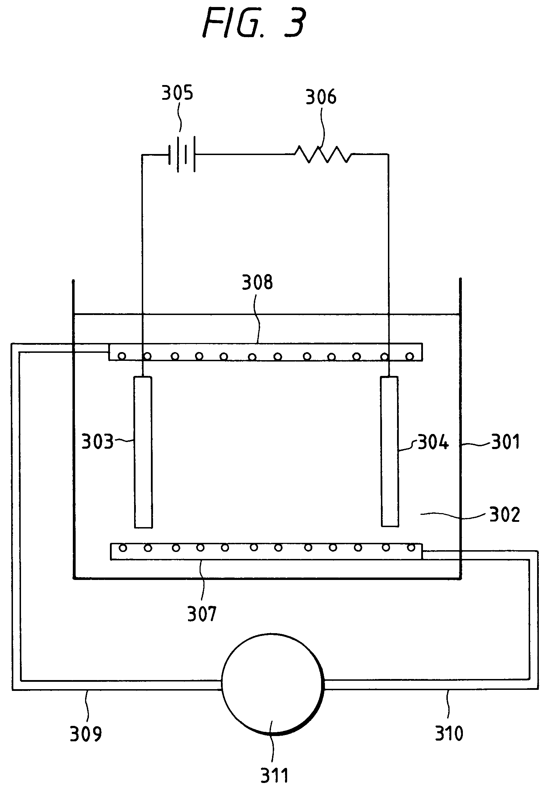

Concretely, a metal layer can be formed, for example, in the apparatus shown in Fig. 3. In Fig. 3, Numeral 301 denotes a anticorrosive vessel, in which a solution 302 comprising, for example, copper ions, pyrophosphorate ions and nitrate ions is held. Numeral 303 denotes an iron-containing substrate, taken as the cathode in the present process.

Numeral 304 denotes an opposite electrode. In this embodiment, copper is used as the opposite electrode 304 which is taken as the anode. The substrate 303 serving as a cathode and the opposite electrode 304 serving as an anode are connected through a load resistor 306 to the power source 305 and are so arranged as to flow a nearly constant current.

Further, to reduce a layer-forming nonuniformity and raise the layer formation speed to improve the efficiency by stirring a solution in the apparatus shown in Fig. 3, a solution circulating system comprising a suction inlet member 308 having a plurality of solution suction holes, a squirt outlet member 307 having a plurality of solution squirt holes similarly, a solution circulating pump 311, a suction solution pipe 309 connecting the solution suction inlet member 308 and the solution circulating pump 311, and a squirt solution pipe 310 connecting the solution squirt outlet member 307 and the solution circulating pump 311 is employed. As the suction inlet member 308 and the squirt outlet member 307, a tube having a plurality of openings serving as a solution suction inlet or a solution squirt outlet can be used as shown in Fig. 3. By using such an apparatus, the electrolysis of a solution is performed to deposit a metal material (e.g., copper) on the substrate 303 and a metal layer is obtained.

With respect to a solution 302 in the present process, the pH is preferably adjusted to 8.0-9.0 and the temperature is preferably in the range of 20°C to 60°C. And the cathode current density is preferably set to be 1-10A/cm². On an iron-containing substrate 303, generally, a good layer formation cannot be obtained from a copper sulphate bath, but according to this method, a metal layer sufficient in close adhesion is formed by making the surface of the substrate 303 uneven, e.g., through etching. In addition, the above-mentioned method involves no great problem in the disposal of waste fluid such as cyanic alkali bath and needs no strike bath.

A single metal layer can be formed by, e.g., using silver cyanide bath or gold cyanide bath according to the above method and plating the substrate with gold, silver or a gold-silver alloy other than copper. In this case, the pH value of a solution is preferably adjusted to 3 to 13, the temperature is preferably set to be in a range of 30°C to 80°C, and the current density is set to be in a range of 3 to 200 mA/cm².

On the other hand, in cases where the metal layer in a photovoltaic device is made a two-layer structure comprising a first metal layer and a second metal layer (e.g., layers 202b and 202c shown in Fig. 2), the first metal layer (layer 202b) is formed by soaking the substrate, for example, into an aqueous solution containing sulfate ions and zinc ions or an aqueous solution containing chlorine ions, zinc ions and ammonia and zinc-plating the substrate taken as the cathode.

Concretely, for example, by using the apparatus shown in Fig. 3, a metal layer can be formed similarly to the single metal layer mentioned above. Especially, in this case, an acid-proof vessel is employed as the anticorrosive vessel 301, either an aqueous solution containing sulfate ions and zinc ions or an aqueous solution containing chlorine ions, zinc ions and ammonia and plating zinc is retained as the aqueous solution 302. The iron-containing substrate 303 is taken as the cathode also in this process.

As the opposite electrode 304, zinc rod is employed in this example. Similarly, the opposite electrode 304 is taken as the anode, the substrate 303 serving as a cathode and the opposite electrode 304 serving as an anode are connected through a load resistor 306 to the power source 305 and are so arranged as to flow a nearly constant current.

Also in this example, to reduce a layer-forming nonuniformity and raise the layer formation speed to improve the efficiency by stirring a solution in the apparatus shown in Fig. 3, a solution circulating system comprising a suction inlet member 308 having a plurality of solution suction holes, a squirt outlet member 307 having a plurality of solution squirt holes similarly, a solution circulating pump 311, a suction solution pipe 309 connecting the solution suction inlet member 308 and the solution circulating pump 311, and a squirt solution pipe 310 connecting the solution squirt outlet member 307 and the solution circulating pump 311 is employed.

In the formation of such first metal layer, the solution 302 is so adjusted that the pH value is preferably in the range of 1.5-4.5 for an aqueous solution containing sulfate ions and zinc ions or preferably in the range of 4.0-7.0 for an aqueous solution containing chlorine ions, zinc ions and ammonia. The temperature is preferably in the range of 10°C to 70°C for an aqueous solution containing sulphate ions and zinc ions or preferably in the range of 10°C to 40°C for an aqueous solution containing chlorine ions, zinc ions and ammonia. And, the cathode current density is preferably set to be 2-80A/cm² for an aqueous solution containing sulfate ions and zinc ions or preferably to be 0.05-20A/cm² for an aqueous solution containing chlorine ions, zinc ions and ammonia.

The first metal layer can be formed by plating the substrate with tin or nickel other than zinc according to the above method. In formation of a tin layer, a solution mainly comprising tin sulfate (about 40g/liter) and sulfuric acid (about 100g/liter) is preferably used, the current density is set to be in a range of 0.1-20 mA/cm² at room temperature and plating is performed. In formation of a nickel layer, Watts bath known as an acidic bath (i.e., mixture bath of nickel sulfate, nickel chloride and boric acid) is used.

The second metal layer (layer 202c shown in Fig. 2) is formed by soaking the substrate, for example, into an aqueous solution containing sulfate ions and copper ions and by copper-plating the substrate taken as the cathode. Similarly to the single metal layer and the first metal layer mentioned above, the second metal layer can be formed in the apparatus shown in Fig. 3. In the anticorrosive vessel 301, a solution 302 comprising sulfate ions and copper ion is retained. As the opposite electrode 304, copper is employed. The stirring of the solution is carried out by the method using a circulation pump as described already. In this case, the temperature of the solution 302 comprising sulfate ions and zinc ions is preferably in the range of 10°C to 70°C, whereas the cathode current density is set to be 0.05-20A/cm².

The second metal layer can be formed by, e.g., using silver cyanide bath or gold cyanide bath according to the above method and plating the substrate with gold, silver or a gold-silver alloy other than copper. In this case, the pH value of a solution is preferably adjusted to 3 to 13, the temperature is preferably set to be in a range of 30^{°}C to 80^{°}C, and the current density is set to be in a range of 3 to 200 mA/cm².

Next, preferably on the metal layer (layer 202a shown in Fig. 1 or layer 202c shown in Fig. 2), a first transparent conductive layer (layer 203 shown in Fig. 1 or 2) is formed by deposition of a material for the conductive layer from a solution. The first transparent conductive layer is formed by soaking a substrate, on which a single metal layer or first and second metal layers are formed, for example, into an aqueous solution containing zinc ions and nitrate ions and by depositing zinc oxide on the metal layer with the substrate taken as a cathode 303 in the apparatus shown in Fig. 3. For the opposite electrode 304 serving as an anode, zinc is employed.

In the formation process of such a transparent conductive layer, the solution 302 is so adjusted that the pH is preferably set to be 4.0-6.3 and the temperature is preferably in the range of 40°C to 70°C. The cathode current density is set to be 0.002-10A/cm², especially preferably 0.01-2A/cm². To stabilize the pH, acetic acid or nitric acid may be added to the solution. As additives for further stabilizing the pH, benzoic acid, formic acid, citric acid, glycolic acid, succinic acid, oxalic acid or the like is employed according as circumstances demand.

Next, the etching of a substrate (substrate 201 shown in Fig. 1 or 2), the formation of a metal layer (layer 202a shown in Fig. 1 or layer 202b and 202c shown in Fig. 2) and the formation of a transparent conductive layer (layer 204 shown in Fig. 1 or 2), any of which is a process relating to a solution (e.g., aqueous solution), can be continuously performed via the water cleaning steps. When a semiconductor layer 205 (shown in Fig. 1 or 2) as an overlying layer is formed by the vacuum process that abhors the moisture, a drying step is performed after the formation of the first transparent conductive layer. For drying, an IR heater heating drying in the atmosphere, a warm wind heating drying with heated oxygen, a vacuum drying and so on are employed.

The formation of the single metal layer, the first and the second metal layers and the first transparent conductive layer is characterized in that the solution can be maintained at an acidic condition throughout all the solution system steps. Accordingly, during the water cleaning and in the transportation of the substrate to the next step, the deterioration of a bath due to the liquid brought in can be minimized. In addition, the path of water cleaning in the intermediate step can be shortened, so that there is an extremely great advantage in the arrangement of a manufacturing equipment.

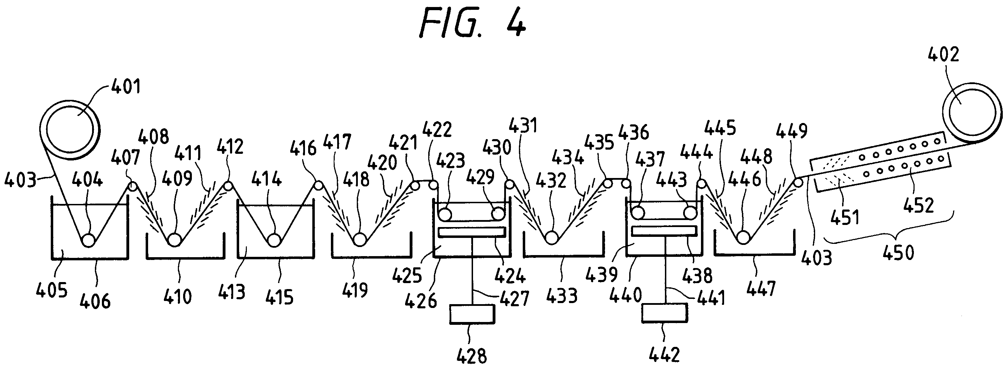

Referring to Fig. 4, one example of apparatus and process for continuously forming a metal layer (single layer) and a first transparent conductive layer in the structure of the device shown in Fig. 1 on a belt-like substrate will be described.

In the apparatus shown in Fig. 4, a substrate roll 403 is delivered by a delivery roller 401 and finally wound by a winding roller 402. Between the delivery roller 401 and the winding roll 402, a degreasing bath 406, a water cleaning bath 410, an etching bath 415, a water cleaning bath 419, a metal layer forming bath 426, a water cleaning bath 433, a transparent conductive layer forming bath 440, a water cleaning bath 447 and a drying furnace 450 are provided in sequence. In the respective baths, rollers 404, 409, 413, 418, 423, 429, 432, 437, 443 and 446 for controlling the conveying path of the substrate roll are provided.

In the apparatus shown in Fig. 4, after degreased and water-cleaned in the baths 406 and 410, respectively, the substrate 403 delivered from the roller 401 is etched with an acidic solution in the bath 415 and cleaned with water in the bath 419, then a metal material is deposited from a solution to form a metal layer (layer 202a shown in Fig. 1) on the substrate 403. Subsequently, after the substrate 403 with the metal layer formed thereon is cleaned with water in the bath 433, a transparent conductive material is deposited from the solution in the bath 440 to form a transparent conductive layer (layer 203 shown in Fig. 1) on the metal layer. Then, after water-cleaned in the bath 447 and dried in the drying furnace 450, the substrate 403 having the metal layer and the transparent conductive layer thereon is wound in by the winding roller 402.

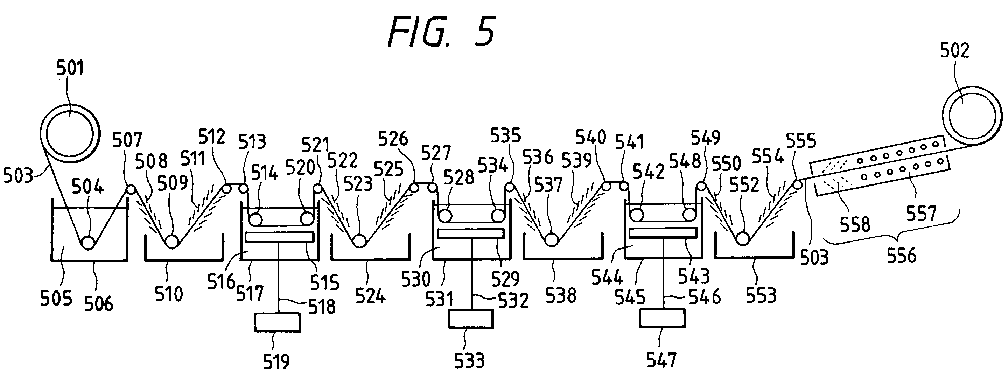

Furthermore, referring to Fig. 5, one example of apparatus and process for continuously forming a first metal layer, a second metal layer and a transparent conductive layer, for example, in the structure of the device shown in Fig. 2 on a belt-like substrate will be described.

In the apparatus shown in Fig. 5, a substrate roll 503 is delivered by a delivery roller 501 and finally wound by a winding roller 502. Between the delivery roller 501 and the winding roll 502, an etching bath 506, a water cleaning bath 510, a first metal layer forming bath 517, a water cleaning bath 524, a second metal layer forming bath 531, a water cleaning bath 538, a transparent conductive layer forming bath 545, a water cleaning bath 553 and a drying furnace 556 are provided in sequence. In the respective baths, rollers 504, 509, 514, 520, 523, 528, 534, 537, 542, 548 and 552 for controlling the conveying path of the substrate roll are provided.

In the apparatus shown in Fig. 5, after the substrate 503 delivered from the roller 501 etched with an acidic solution in the bath 506 and cleaned with water in the baths 510, a metal material is deposited from a solution to form a first metal layer (layer 202b shown in Fig. 2) on the substrate 503. Next, after the water cleaning in the bath 531, another metal material is deposited from another solution to form a second metal layer (layer 202c shown in Fig. 2) on the substrate 503. Subsequently, after the substrate 503 with the first and the second metal layers formed thereon is cleaned with water in the bath 538, a transparent conductive material is deposited from a solution in the bath 545 to form a transparent conductive layer (layer 203 shown in Fig. 2) on the metal layer. Then, after cleaned with water in the bath 553 and dried in the drying furnace 556, the substrate 503 having the metal layers and the transparent conductive layer thereon is wound in by the winding roller 502.

On a substrate provided with the metal layer (or first and second metal layers) and the transparent conductive layer, a predetermined treatment is exerted to form a semiconductor layer (layer 204 shown in Fig. 1 or 2) on the transparent conductive layer.

A semiconductor layer 204 according to the present invention comprises at least one of pn junction, pin junction, Schottky junction and hetero junction, across both side of which an electromotive force is generated in response to an incident ray of light. The current due to the generated electromotive force flows through the current path composed of the second transparent conductive layer (layer 205 shown in Fig. 1 or 2) formed as the upper layer, the first transparent conductive layer (layer 203 shown in Fig. 1 or 2) formed as the lower layer, the substrate 201 connected via the metal layer 202a or via the first and the second metal layers 202b and 202c, and the load coupled with them. The second transparent conductive layer formed as the upper layer is restricted in film thickness and might have no sufficient current capacity because of bearing the role of reflection preventive layer and at that time a grid electrode is further provided.

By using the CVD method in which a gas is excited under influence of LF discharge, RF discharge, VHF discharge or micro wave discharge, a semiconductor layer can be obtained as a layer having pn junction, pin junction, Schottky junction or hetero junction and comprising amorphous or crystalline silicon, amorphous or crystalline silicon/germanium, amorphous or crystalline silicon carbide or the like, and as a multilayered structure known as tandem or triple, comprising these.

Next, on the semiconductor layer, a second transparent conductive layer (layer 206 shown in Fig. 1 or 2) is formed by the vacuum deposition method, the sputtering method, the reactive sputtering method and the CVD method. As materials for such a transparent conductive layer, ITO, In₂O₃, SnO₂, ZnO and TiO₂, for example, can be employed. Needless to say, they may be employed in a stacked state.

Next, the function of a photovoltaic device obtained in the present invention will be described referring to the devices of structures shown in Figs. 1 and 2.

The light incident from above the photovoltaic device is made to be in a reflection preventive state at a certain central wavelength in the second transparent conductive layer 205, enters the semiconductor layer 204 and generates photocarriers in the semiconductor layer 204. Corresponding to their two charge types, the photocarriers generated are collected to the side of the second transparent conductive layer 205 or through the first transparent conductive layer 203 and the metal layer 202a or the second and the first metal layers 202c and 202b to the side of the substrate 201. The light not absorbed by the semiconductor layer 204 passes through the first transparent conductive layer 203, reflected from the metal layer 202a or the second metal layer 202c, passes through the first transparent conductive layer 203 again and returns to the semiconductor layer 204. For that reason, the reflection capacity of the metal layer 202a in the structure shown in Fig. 1 or that of the second metal layer 202c in the structure shown in Fig. 2 is very important.

Since a ray of light with a by far longer wavelength than that of the band edge in the semiconductor layer 204 is hardly absorbed further by the semiconductor layer 204 even if returns to the semiconductor layer 204 after the reflection, it is important that the reflection capacity of the metal layer 202a or the second metal layer 202c is superior near the absorption edge of the semiconductor layer 204.

In addition, when the metal layer 202a or the second metal layer 202c has unevenness or the first transparent conductive layer 203 has unevenness, a ray of light rebounding by the reflection from the metal layer 202a or the second metal layer 202c or by the refraction in the first transparent conductive layer 203 goes slantwise and takes a large optical path, so that the quantity of light absorbed by the semiconductor layer 204 due to an effect usually called light confinement can be increased, resulting in an increase in photocurrent. This unevenness is preferably on the order of the wavelength at the absorption edge of the semiconductor layer 204.

In the present invention, the unevenness of the metal layer 202a, or the first and the second metal layer 202b and 202c, and the first transparent conductive layer 203 is obtained by performing the first formation of unevenness when etching the substrate 201, the subsequent formation of unevenness when a metal layer 202a or a first metal layer 202b and/or a second metal layer 202c is formed, and further the formation of the unevenness when a transparent conductive layer is formed. It gives a preferred result to an increase in the current of a photovoltaic device that the unevenness formed in the interface between the metal layer 202a or the second metal layer 202c and the first transparent conductive layer 203 and the unevenness formed between the first transparent conductive layer 203 and the semiconductor layer 204 are different in shape rather than like in shape.

On the other hand, for the photovoltaic device, a long-term stable operation is desired in the outdoor environment. For this reason, a sufficient durability against a mechanical bending is required depending on the temperature, the humidity and the conditions of installment. Because of being destined to be placed under the sunshine, a photovoltaic device must be adaptable to a wide range of temperature change from a high temperature near to 100°C in the day time of summer to a low temperature of -30°C or less at the dawn of winter. Furthermore, since a change of tens of degrees in Celsius takes place during a day and the respective layers 202-205 stacked on the substrate 201 have different thermal coefficients, peeling often occurs in the interfaces. Especially when the film thickness is larger, this trouble becomes significant.

The semiconductor layer 204 composed of amorphous silicon or amorphous silicon/germanium is on the order of several hundreds nm in thickness, the second transparent conductive layer 205 is around 60nm thick, the first transparent conductive layer 203 is around 1 µm thick and the metal layer 202a or the second metal layer 203c is 200-500nm thick, the peeling is observed first between the first transparent conductive layer 203 and the metal layer 202a or the second metal layer 203c and secondly between the metal layer 202a or the second metal layer 203c and the substrate 201.

Such peeling is prevented by preparing the surface of an underlying layer as a clean surface before film formation, forming the unevenness on the underlying surface to enlarge the surface area and promote the close adhesion, dividing the interface into small regions so that the thermal expansion or contraction may not spread over the whole layer, and other means.

As a method according to the present invention, for example, the iron-containing substrate is etched with a hot aqueous solution containing hydrofluoric acid and nitric acid to make the surface into an uneven surface as mentioned above. In addition, a metal layer 202a or a first metal layer 202b and/or a second metal layer 202c is deposited on it to make the surfaces uneven. Furthermore, a first transparent conductive layer 203 is deposited on it to grow into crystal grains on the order of wavelength of light and becomes a condition that the space between the crystal grains is filled with a different phase, so that the thermal expansion or contraction does not extend over the whole layer. This is important also when the substrate is bent under application of a physical force and acts advantageously especially when manufacturing a very elastic photovoltaic device with the substrate being flexible. In addition, especially in the film formation of a metal layer 202a or a second metal layer 202c and a first transparent conductive layer 203 according to the present invention, so high a temperature as several hundreds of degree in Celsius is not required to obtain the needed unevenness and no great thermal shock is applied by nature.

According to experiments by the inventors, it is found that the repetition of temperature cycles in a humid environment leads to the occurrence of cracks in the first transparent conductive layer 203 and these cracks become penetrating paths of water, and that, in a module comprising a series connection of several photovoltaic devices as submodules, a reverse voltage is applied to the photovoltaic device in the state called a partial shade in which only a part is shaded, and consequently the metal forming the metal layer 202a or the second metal layer 202c generates a branch growth based on an electrochemical migration, thereby causing a shunt of the device.

In cases where the first transparent conductive layer 203 is formed minutely and rigidly over the whole layer, these phenomena occur and becomes noticeable especially when it is formed by a high-temperature vacuum process such as sputtering. Such a shunt of the device due to the branch growth are not recovered thereafter even when the ambient humidity is lowered and the moisture is lost. Since the first transparent conductive layer 203 obtained by a method according to the present invention grows originally from an aqueous solution to form a layer, the relaxation to water acts and the problems mentioned above can be minimized.

Hereinafter, the present invention will be described along Examples in further detail, but the present invention is not limited to these Examples.

### Example 1

In this Example, a photovoltaic device comprising the layer constitution shown in Fig. 1 was manufactured by forming a metal layer, a first transparent conductive layer, a semiconductor layer and a second transparent conductive layer in sequence on a substrate by using the aforesaid apparatus shown in Fig. 4. As the substrate, a thin plate of stainless steel 430A formed in a roll shape was used.

In the equipment shown in Fig. 4, the process speed of a substrate roll 403 was set to be 20cm/min. The tension applied to the substrate roll 403 was set to be 10kg and was controlled by using a tension control clutch not shown, incorporated into a winding roller 102.

Hereinafter, the description will proceed following the sequence of steps.
(1-1) The substrate roll 403 subjected to rust-preventive treatment was soaked in the degreasing bath 406 to degrease the oil content. The degreasing bath liquid 405 was an aqueous solution comprising a mixture of 60ml of sulfuric acid and 70ml of hydrochloric acid (37% hydrogen chloride water; used similarly hereinafter). The temperature was set to be room temperature.
(1-2) The substrate roll 403 after the completion of the step (1-1) was conveyed through the conveyance roller 407 to the water cleaning bath 410. By using cleaning showers 408 and 411, water cleaning is sufficiently accomplished. At that time, the quantity of water is preferably at least 2 liter/min.
(1-3) The substrate roll 403 after the completion of the step (1-2) was conveyed through the conveyance roller 412 to the acidic etching bath 415 and etching of the degreased substrate 403 was performed. The employed acidic etching bath liquid was made by mixing 3 parts of hydrofluoric acid (46% hydrogen fluoride water; used similarly hereinafter) and 1 part of acetic acid based on 5 parts of nitric acid, and the liquid temperature is made equal to room temperatures.
(1-4) The substrate roll 403 after the completion of the step (1-3) was conveyed to the water cleaning bath 419 similar to the clean bath after the degreasing. Since the metal layer forming bath liquid in the next step is alkaline, a weakly alkaline shower can be substituted for this water cleaning bath 419.
(1-5) The substrate roll 403 after the completion of the step (1-4) was conveyed through the conveyance rollers 421 and 422 to the metal layer forming bath 426, and a metal layer (layer 202a shown in Fig. 1) comprising copper was formed on the etched substrate 403. The metal layer forming bath liquid was a mixture of 80g of copper pyrophosphate, 300g of potassium pyrophosphate, 6ml of ammonia water (sp.gr. 0.88) and 10g of potassium nitrate, made up with 1 liter of water and the liquid temperature was controlled to be 50°C to 60°C. The pH of the liquid was set in the range of 8.2-8.8.
   For the anode, a copper sheet was employed. In this equipment, because the substrate roll 403 was at the ground potential, the formation of a film was controlled by reading the current on the copper sheet of the anode. In this Example, the current density was set at 3A/cm². The layer formation speed was 6nm/s and a metal layer formed in the metal forming bath was 400nm thick.
(1-6) The substrate roll 403 after the completion of the step (1-5) was cleaned in the water cleaning bath 433. Then, the substrate roll 403 was conveyed through the conveyance rollers 435 and 436 to the transparent conductive layer forming bath 440, and a transparent conductive layer (203 shown in Fig. 1) comprising zinc oxide was formed on the metal layer. The transparent conductive layer forming bath liquid 439 was a mixture of 30g of zinc nitrate hexahydrate and 10ml of nitric acid, made up with 1 liter of water and the liquid temperature was maintained at 60°C. The pH of the liquid was set to be 5.2-5.8. As the opposite electrode, zinc with the surface subjected to buffing was employed. The current density flowing through the opposite electrode was set to be 2A/cm². The layer forming speed was 18nm/s and a first transparent conductive layer 408 formed in the first transparent conductive layer forming bath was 1 µm thick.
(1-7) The substrate roll 403 after the completion of the step (1-6) was cleaned in the water cleaning bath 447. Then, the substrate roll 403 was conveyed through the conveyance rollers 449 to the drying furnace 450. The drying furnace 450 comprises a warm wind nozzle 451 and a IR heater 452, and water repulsion was also performed simultaneously in the warm wind nozzle 451. The temperature of warm wind in the warm wind nozzle 451 was set at 150°C and that of the IR heater 452 was set at 200°C.
(1-8) The substrate roll 403 through the drying step of the step (1-7) was ground in by the winding roller 402. In this manner, a base member for the device shown in Fig. 1 was obtained in which a metal layer 202 and a first transparent conductive layer 203 are formed on the iron-containing substrate 201.
   In the aforesaid metal layer forming bath 426 and transparent conductive layer forming bath 440, air stirring and mechanical stirring were employed, respectively. For the both baths, the pH of the bath liquid was always monitored with a pH meter incorporating the temperature correction using the glass electrode. By addition of ammonia to the metal layer forming bath 426 and addition of nitric acid to the transparent conductive bath 440, the pH of the respective baths was controlled.
(1-9) On the base member formed by the steps 1) to (1-8), i.e., with a metal layer 202 and a first transparent conductive layer 203 stacked in sequence on the substrate 201, a triple-structured semiconductor layer 204 comprising three sets of p-i-n structures was formed in the CVD apparatus applying to a belt-like substrate wound in the shape of a roll.
(1-10) By using a gas mixture of silane, phosphine and hydrogen and heating the substrate at 340°C, 400W of RF power was applied to form a n-type layer. Next, by using a gas mixture of silane and germanium hydride and setting the substrate temperature at 450°C, microwave power was applied to form an i-type layer. Furthermore, by setting the substrate temperature at 250°C, a p-type layer was formed from a gas mixture of boron trifluoride, silane and hydrogen to make a bottom pin layer.
(1-11) Except that the mixing ratio of silane and germanium was increased in forming an i-type layer, a middle p-i-n layer was formed similarly to the step (1-10).
(1-12) Except that the mixing ratio of silane and hydrogen was employed in forming an i-type layer, a top p-i-n layer was formed similarly to the step (1-10).
(1-13) On the semiconductor layer 204 formed by steps (1-9) to (1-12), a second transparent conductive layer 205 comprising ITO was deposited. As the deposition apparatus, a sputtering apparatus applying to a belt-like substrate ground in the shape of a roll was employed similarly to the formation of a semiconductor layer.
(1-14) By using silver paste, electrode pickup treatment was performed to obtain a photovoltaic device of the structure shown in Fig. 1.

For purposes of comparison with this, a photovoltaic device of the structure shown in Fig. 1 was obtained in accordance with the operation and design similar to those described above except that both a metal layer comprising copper and a transparent conductive layer comprising zinc oxide were formed by the sputtering method.

The layer formation by sputtering was performed by using parallel plat plate type DC magnetron sputtering apparatus, ZnO sintered target for ZnO layer, a metal target for a metal layer, argon gas under the condition of 1.2 Pa and discharge power: 2.5 W/cm². The substrate temperature for formation of ZnO layer was set to be 200^{°}C, and the substrate temperature for formation of a metal layer was set to be room temperature (without particular heating).

On the photovoltaic device manufactured by the aforesaid steps (1-1) to (1-14) and the photovoltaic device with layers comprising copper and zinc oxide, formed by the sputtering method, photoelectric conversion characteristics were examined by irradiation of a simulator lamp.

Specifically, as the simulator lamp, an usual illumination type xenon lamp spectrum-corrected by a filter, its spectrum was set to be AM1.5 and the amount of light illumination on a sample-mounting table was set to be 100 mW/cm². A sample temperature was maintained at 25^{°}C by water-cooling the sample table. Under the simulator lamp, current-voltage characteristics were measured by scanning a voltage for applying to a photovoltaic device. The maximum value of product of current and voltage in the obtained current-voltage characteristics curve is a maximum power. Energy conversion efficiency was calculated by dividing this value by the amount of incident light area-corrected.

The comparative study revealed that the photovoltaic device manufactured by the aforesaid steps (1-1) to (1-14) has 1.1 times the energy conversion efficiency of the photovoltaic device with copper and zinc oxide deposited on a stainless steel by the sputtering method.

Next, the aforesaid two types of photovoltaic devices placed in an environmental test box of 85°C/85%RH and with the lapse of time, photoelectric conversion characteristic was monitored with 1V of reverse bias applied.

As a result, the photovoltaic device with copper and zinc oxide deposited on a stainless steel by the sputtering method approached a shunt level of disabled state in 10 minutes and became unable to be used in one hour. In contrast to this, the photovoltaic device manufactured by the aforesaid steps (1-1) to (1-14) could maintain a shunt level of usable state during a period of 15 hours.

In Example 1, as the metal layer forming bath liquid 425, an aqueous solution comprising 80g of copper pyrophosphate, 300g of potassium pyrophosphate, 6 ml of ammonia water (sp.gr. 0.88) and 10g of potassium nitrate dissolved in 1 liter of water was chosen, but used quantities may be in the range of 60-110g for copper pyrophosphate, 100-500g for potassium pyrophosphate, 1-10ml for ammonia water and 5-20g for potassium nitrate. Potassium pyrophosphate contributes to the unevenness of copper formed into a film and a great amount of it inhibits the unevenness. In addition, when an excess of it is put in the bath liquid, generation of orthophosphoric acid occurs, thus leading to a decrease in current density. A smaller amount of potassium nitrate and ammonia water contribute to an increase in unevenness. From the standpoint of close adhesion, a certain degree of their presence is preferable.

In Example 1, as the transparent conductive layer forming bath liquid 439, an aqueous solution comprising 30g of zinc nitrate hexahydrate and 10ml of nitric acid dissolved in 1 liter of water was chosen, but 1g-80g of zinc nitrate hexahydrate may be used, nitric acid is not added or may be added to the upper limit of 50ml, and 3-20ml of acetic acid may be added for the purpose of facilitating the control of pH. The unevenness of a film formed depends on the temperature and the film forming speed. When a film is formed slowly at a high temperature, a relatively flat film with good crystal orientation and close adhesion is obtained. When a film is formed rapidly at a low temperature, a highly uneven film is obtained. These conditions should be selected in accordance with the wavelength of light in which the light confinement effect needed for the semiconductor layer 204.

Furthermore, in Example 1, an example where the semiconductor layer 204 was formed as a triple layer of p-i-n structure by the CVD method was shown, but other methods than the CVD is applicable if only they can form a semiconductor film at several hundreds of degrees in Celsius. Materials to which the aforesaid photovoltaic device manufacturing method is applicable are, for example, ZnS, SnSe, crystalline silicon and CuInSe.

### Example 2

In this Example, except that the temperature for each water cleaning and for each bath was set to about 50°C over all steps, a metal layer and a transparent conductive layer were formed on a substrate as the structure shown in Fig. 1 in substantially the same manner as that of Example 1.

However, the etching bath liquid comprising a mixture of 3 parts of nitric acid, 2 parts of hydrofluoric acid and 3 parts of acetic acid, the same metal layer forming bath liquid as in Example 1 and the transparent conductive layer forming bath liquid 439 comprising 30g of zinc nitrate hexahydrate, 10ml of nitric acid and 5ml of acetic acid dissolved in 1 liter of water were employed. The current density was set to 2A/cm² for the metal layer forming bath liquid and 0.4A/cm² for the transparent conductive layer forming bath liquid 439. At that time, the layer forming speed and film thickness were set to 3nm/s and 200nm for the metal layer 202 and 1nm/s and 1200nm for the first transparent conductive layer 203.

On the first transparent conductive layer 203 obtained in this way, a triple-structured semiconductor layer 204 and a second transparent conductive layer 205 were formed in a manner similar to that of Example 1, to obtain a photovoltaic device of the structure shown in Fig. 1.

On the photovoltaic device manufactured in Example 2, photoelectric conversion characteristic was examined by irradiating a simulator lamp. The measuring conditions were to be the same as those of Example 1.

As a result, it was revealed that the photovoltaic device manufactured in Example 2 had 1.06 times the energy conversion efficiency for that manufactured in Example 1 with copper and zinc oxide deposited on a stainless steel by using a sputtering apparatus.

Next, the photovoltaic devices manufactured in this Example was placed in an environmental test box of 85°C/85%RH and with the lapse of time, photoelectric conversion characteristic was monitored with 1V of reverse bias applied.

As a result, the photovoltaic device manufactured in this Example could maintain a shunt level of usable state during a period of 17 hours and exhibited an excellent stability.

With a method of Example 2, since temperature is constant over all steps, the inconvenience of conditions largely changing from the set values can be avoided which would have been effected every time the substrate roll enters the respective bath. In addition, the length of the whole equipment becomes also possible to minimize. Thus, Example 2 can contribute to the cost reduction of a manufacturing equipment, so that an inexpensive and simple photovoltaic device can be implemented.

### Example 3

In this Example, by using a 1mm thick and 5cm square stainless steel 304 ground into a mirror plane as the substrate 201 and by using a plurality of apparatus shown in Fig. 3, a metal layer 202a and a first transparent conductive layer 203 were formed in a batch process.

The substrate was retained by interposing it in a clip made of stainless steel and at the same time this clip was employed as a current path when the substrate taken as a cathode.

Water cleaning was performed by using two water containers of the same size shown in Fig. 3 for each water cleaning step.

By using an alkaline cleanser mainly comprising caustic soda employed as the degreasing bath liquid, degreasing was performed at 50°C for 10 minutes.

With a 1:1 mixture of nitric acid and hydrofluoric acid employed as etching bath liquid, etching was performed at 25°C for 3 minutes.

With an aqueous solution comprising 80g of copper pyrophosphate, 150g of potassium pyrophosphate, 2ml of ammonia water (sp.gr. 0.88) and 5g of potassium nitrate dissolved in 1 liter of water was employed as the metal layer forming bath liquid, a 150nm thick metal layer 202a with unevenness was formed on the substrate 201 at a liquid temperature of 25°C and a cathode current density of 1A/cm².

With an aqueous solution comprising 50g of zinc nitrate hexahydrate and 20ml of nitric acid dissolved in 1 liter of water employed as the transparent conductive layer forming bath liquid, a 500nm thick first transparent conductive layer 203 was formed at a liquid temperature of 62°C and a cathode current density of 0.2A/cm².

For any of degreasing bath, etching bath, metal layer forming bath and transparent conductive layer forming bath, a solution stirring was performed by using the bath circulating apparatus shown in Fig. 3. The formed first transparent conductive layer 203 indicated a crystal structure of wurtzite type on the RHEED and presented crystal grains of 1 µm size in a SEM image. With other operations, conditions and design items similar to those of Example 1, a metal layer and a first transparent conductive layer were formed.

On the first transparent conductive layer 203 obtained in this way, a single pin-structured semiconductor layer 204 and a second transparent conductive layer 205 were formed in a manner similar to that of Example 1 to obtain a photovoltaic device of the structure shown in Fig. 1.

For the comparative study to this, except that a metal layer comprising copper and a transparent conductive layer comprising zinc oxide was formed on a stainless steel substrate by the sputtering method, a photovoltaic device of the structure shown in Fig. 1 was obtained in accordance with an operation and design similar to those described above.

On the photovoltaic device manufactured in Example 3 and the photovoltaic device with copper and zinc oxide deposited on a stainless steel substrate by the sputtering method, photoelectric conversion characteristic was examined by irradiating a simulator lamp. The measuring conditions were to be the same as in Example 1.

As a result, it was revealed that the photovoltaic device according to Example 3 with a metal layer and a first transparent conductive layer formed using the aforesaid apparatus shown in Fig. 3 had 1.2 times the energy conversion efficiency for that manufactured in Example 1 with copper and zinc oxide deposited on a stainless steel by using a sputtering apparatus. Thus, a photovoltaic device according to Example 3 was judged to have a large effect of light confinement.

Next, the aforesaid two types of photovoltaic devices was placed in a environmental test box of 85°C/85%RH and with the lapse of time, photoelectric conversion characteristic was monitored with 1V of reverse bias applied.

As a result, the photovoltaic device with copper and zinc oxide deposited on a stainless steel substrate by the sputtering method approached a shunt level of disabled state in 5 minutes and became impossible to use in 40 minutes. In contrast to this, the photovoltaic device manufactured in Example 3 with a metal layer and other layers formed using the apparatus shown in Fig. 3 could maintain a shunt level of usable state during a period of 10 hours.

With a method according to Example 3, the operating time and liquid temperature are free as compared with the manufacturing process using a substrate roll and the control of current becomes possible by a direct control of the cathode current. In addition, since various maintenances and inspections can be individually effected, a manufacturing process with a high degree of freedom can be constructed.

### Example 4

In this Example, with the aid of the equipment shown in Fig. 5, a photovoltaic device comprising the layer constitution shown in Fig. 2 was manufactured by forming a semiconductor layer and a second transparent conductive layer after a first metal layer, a second metal layer and a first transparent conductive layer were formed on a substrate.

In the apparatus shown in Fig. 5, the process speed of the substrate roll 503 was set to 20cm/minutes. The tension applied to the substrate roll 503 was set to 10kg and was controlled with the aid of a tension control clutch not shown, built in the winding roller 502.

Hereinafter, the manufacturing procedure will be described in accordance with the sequence of steps.
(4-1) The substrate roll 503 was allowed to pass through the interior of the acidic etching bath 506 and was etched with hydrofluoric acid and nitric acid. The employed acidic etching bath liquid was made by mixing 3 parts of hydrofluoric acid (46% hydrogen fluoride water; similarly hereinafter) and 1 part of acetic acid based on 5 parts of nitric acid, and the liquid temperature was set to room temperature.
(4-2) The substrate roll 503 after the completion of the step (4-1) was conveyed through the conveyance roller 507 to the water cleaning bath 510. By using a wash-cleaning showers 508 and 511, water cleaning was sufficiently accomplished. At that time, the quantity of water is preferably at least 2 liter/min.
(4-3) The substrate roll 503 after the completion of the step (4-2) was conveyed through the conveyance rollers 512 and 513 to the first metal layer forming bath 517, and a first metal layer (layer 202b shown in Fig. 2) comprising zinc was formed on the etched substrate 503. The first metal layer forming bath liquid 516 was a mixture of 300g of zinc sulfate and 30 g of ammonium sulfate, made up with 1 liter of water and the liquid temperature was controlled to 50°C to 60°C. The pH of the liquid was set to be in the range of 3.0-4.0.
   For the anode, a zinc sheet was employed. In this equipment, because the substrate roll 503 was at the ground potential, the formation of a film was controlled by reading the current on the zinc sheet of the anode. In this Example, the current density was set to 30A/cm². The layer formation speed was 5nm/s and a first metal layer 502 formed in the first metal forming bath was 200nm thick. Thereafter, the substrate roll 503 was conveyed through the conveyance roller 521 to the water cleaning bath 524. Water cleaning was sufficiently effected with the cleaning showers 522 and 525.
(4-4) The substrate roll 503 after the completion of the step (4-3) was conveyed through the conveyance rollers 526 and 527 to the second metal layer forming bath 531, and a second metal layer (layer 202c shown in Fig. 2) comprising copper was formed on the first metal layer. The second metal layer forming bath liquid 530 was a mixture of 150g of copper sulfate and 50 g of sulfuric acid, made up with 1 liter of water and the liquid temperature was controlled to 20°C to 25°C.
   For the anode, a copper sheet was employed. The current density was set to 3A/cm². In this manner, a second metal layer having a thickness of 300nm was obtained.
(4-5) The substrate roll 503 after the completion of the step (4-4) was cleaned in the water cleaning bath 538. Then, the substrate roll 503 was conveyed through the conveyance rollers 540 and 541 to the transparent conductive layer forming bath 545 and a first transparent conductive layer 504 (203 shown in Fig. 2) comprising zinc oxide was formed on the second metal layer. The transparent conductive layer forming bath liquid 544 was a mixture of 30g of zinc nitrate hexahydrate and 10ml of nitric acid, made up with 1 liter of water and the liquid temperature was maintained at 60°C. The pH of the liquid was set to 5.2-5.8. As the opposite electrode, zinc with the surface subjected to buffing was employed. The current density flowing through the opposite electrode was set to 2A/cm². The layer forming speed was 18nm/s and a first transparent conductive layer 204 formed in the first transparent conductive layer forming bath was 1 µm thick.
(4-6) The substrate roll 503 after the completion of the step (4-5) was cleaned with water in the water cleaning bath 553. Then, the substrate roll 503 was conveyed through the conveyance rollers 555 to the drying furnace 556. The drying furnace 556 comprises a warm wind nozzle 557 and a IR heater 558, and water repulsion was also performed simultaneously in the warm wind nozzle 557. The temperature of warm wind in the warm wind nozzle 557 was set to 150°C and that of the IR heater 558 was set to 200°C.
(4-7) The substrate roll 503 through the drying step of the step (4-6) was ground in by the winding roller 502. In this manner, a base member for the device shown in Fig. 2 was obtained in which a first metal layer 202b, a second metal layer 202c and a first transparent conductive layer 203 are formed on the iron-containing substrate 201.
   In the aforesaid first and second metal layer forming baths 517 and 531 and transparent conductive layer forming bath 545, air stirring and mechanical stirring were employed, respectively. For all three baths, the pH of the bath liquid was always monitored with a pH meter incorporating the temperature correction using the glass electrode. By addition of zinc sulfate to the first metal layer forming bath 517, addition of copper sulfate and ammonia to the second metal layer forming bath 531, and addition of nitric acid to the transparent conductive bath 545, the pH in the respective baths was controlled.
(4-8) On the base member formed by the steps (4-1) to (4-7), i.e., with a first metal layer 202b, a second metal layer 202c and a transparent conductive layer 203 stacked in sequence on the substrate 201, a triple-structured semiconductor layer 204 was formed in the CVD apparatus applicable to a belt-like substrate wound in the shape of a roll in accordance with a method and conditions similar to those of steps (1-9) to (1-12).
(4-9) On the semiconductor layer 204 formed by step (4-8), a second transparent conductive layer 205 comprising ITO was deposited. As the deposition apparatus, a sputtering apparatus applicable to a belt-like substrate ground in the shape of a roll was employed similarly to the formation of a semiconductor layer.
(4-10) By using silver paste, electrode pickup treatment was performed to obtain a photovoltaic device of the structure shown in Fig. 2.

For purposes of comparison with this, a photovoltaic device of the structure shown in Fig. 2 was obtained in accordance with the operation and design similar to those described above except that a first metal layer comprising zinc, a second metal layer comprising copper and a first transparent conductive layer comprising zinc oxide were formed by the sputtering method.

On the photovoltaic device manufactured by the aforesaid steps (4-1) to (4-10) and the photovoltaic device with the metal layers and the like formed by the sputtering method, photoelectric conversion characteristics were examined by irradiation of a simulation lamp.

The comparative study revealed that the photovoltaic device manufactured by the aforesaid steps (4-1) to (4-10) has a 1.12 times the energy conversion efficiency of the photovoltaic device with zinc, copper and zinc oxide deposited on a stainless steel by the sputtering method.

Next, the aforesaid two types of photovoltaic devices placed in a environmental test box of 85°C/85%RH and with the lapse of time, photoelectric conversion characteristic was monitored with 1V of reverse bias applied.

As a result, the photovoltaic device with zinc, copper and zinc oxide deposited on a stainless steel by the sputtering method approached a shunt level of disabled state in 10 minutes and became unable to be used in one hour. In contrast to this, the photovoltaic device manufactured by the aforesaid steps (4-1) to (4-10) could maintain a shunt level of usable state during a period of 15 hours.

In Example 4, as the first metal layer forming bath liquid 516, an aqueous solution comprising 300g of zinc sulfate and 30g of ammonium sulfate, dissolved in 1 liter of water was chosen, but used quantities may be in the range of 150-450g for zinc sulfate and 5-50g for ammonium sulfate. The other buffer solutions include magnesium sulfate, sodium sulfate, aluminum sulfate, sodium acetate, sodium chloride and boric acid. These buffer solutions can be used in quantities of 1g to 80g.

In Example 4, as the transparent conductive layer forming bath liquid 544, an aqueous solution comprising 30g of zinc nitrate hexahydrate and 10ml of nitric acid dissolved in 1 liter of water was chosen, but 1g-80g of zinc nitrate hexahydrate may be used, nitric acid is not added or may be added to the upper limit of 50ml, and 3-20ml of acetic acid may be added for the purpose of facilitating the control of pH. The unevenness of a film formed depends on the temperature and the film forming speed. When a film is formed slowly at a high temperature, a relatively flat film with good crystal orientation and close adhesion is obtained. When a film is formed rapidly at a low temperature, a highly uneven film is obtained. These conditions should be selected in accordance with the wavelength of light in which the light confinement for the semiconductor layer 204.

Furthermore, in Example 4, an example where a triple layer of p-i-n structure was formed by the CVD method was shown as the semiconductor 204, but other methods than the CVD is applicable if only they can form a film at several hundreds of degrees in Celsius. Materials for a semiconductor layer 204 to which the aforesaid photovoltaic device manufacturing method is applicable are, for example, ZnS, SnSe, crystalline silicon and CuInSe.

### Example 5

In this Example, except that the temperature for each water cleaning and for each bath was set to about 50°C over all steps, first and second metal layers and a first transparent conductive layer were formed on a substrate in accordance with the structure shown in Fig. 2 in substantially the same manner as in Example 4.

However, the etching bath liquid comprising a mixture of 3 parts of nitric acid, 2 parts of hydrofluoric acid and 3 parts of acetic acid, the same first and second metal layer forming bath liquids as in Example 4 and the transparent conductive layer forming bath liquid comprising 30g of zinc nitrate hexahydrate, 10ml of nitric acid and 5ml of acetic acid dissolved in 1 liter of water were employed. The current density was set to 2A/cm² for the metal layer forming bath liquid and 0.4A/cm² for the transparent conductive layer forming bath liquid. At that time, the layer forming speed and film thickness were set to 7nm/s and 100nm for the first metal layer 202b, respectively; 5nm/s and 200nm for the second metal layer 202c, respectively; and 1nm/s and 1200nm for the first transparent conductive layer 203.

On the first transparent conductive layer 203 obtained in this way, a triple-structured semiconductor layer 204 and a second transparent conductive layer 205 were formed in a manner similar to that of Example 4, and a photovoltaic device of the structure shown in Fig. 2 was obtained.

On the photovoltaic device manufactured in Example 5, photoelectric conversion characteristic was examined by irradiating a simulator lamp. The measuring conditions were to be the same as with Example 1.

As a result, it was revealed that the photovoltaic device manufactured in Example 5 had 1.07 times the energy conversion efficiency for that manufactured for comparison in Example 4 with copper, zinc oxide and so on deposited on a stainless steel by using a sputtering apparatus.

Next, the photovoltaic devices manufactured in this Example was placed in a environmental test box of 85°C/85%RH and with the lapse of time, photoelectric conversion characteristic was monitored with 1V of reverse bias applied.

As a result, the photovoltaic device manufactured in this Example could maintain a shunt level of usable state during a period of 17 hours and exhibited an excellent stability.

With a method of Example 5, since temperature is constant over all steps, the inconvenience of conditions largely changing from the set values can be avoided which would have been effected every time the substrate roll enters the respective bath. In addition, the length of the whole equipment becomes also possible to minimize. Thus, Example 2 can contribute to the cost reduction of a manufacturing equipment, so that an inexpensive and simple photovoltaic device can be implemented.

### Example 6

In this Example, by using a 1mm thick and 5cm square stainless steel 304 ground into a mirror plane as the substrate 201 and by using a plurality of equipment sets shown in Fig. 3, first and second metal layers 202b and 202c and a first transparent conductive layer 203 were formed in a batch process.

The substrate was retained by interposing it in a clip made of stainless steel and at the same time this clip was employed as a current path when the substrate taken as a cathode.

Water cleaning was performed by using two water containers of the same size shown in Fig. 3 for each water cleaning step.

By using a 1:1 mixture of nitric acid and hydrofluoric acid employed as etching bath liquid, etching was performed at 25°C for 3 minutes.

An aqueous solution comprising 200g of zinc sulfate and 60 g of magnesium sulfate dissolved in 1 liter of water was employed as the first metal layer forming bath liquid, a 150nm thick uneven first metal layer 202b comprising zinc was formed on the substrate 201 at a liquid temperature of 25°C and a cathode current density of 20A/cm².

With an aqueous solution comprising 240g of copper sulfate, 60g of sulfuric acid dissolved in 1 liter of water was employed as the second metal layer forming bath liquid, a 150nm thick uneven second metal layer 202b comprising copper was formed on the substrate 201 at a liquid temperature of 25°C and a cathode current density of 2A/cm².

With an aqueous solution comprising 50g of zinc nitrate hexahydrate and 20ml of nitric acid dissolved in 1 liter of water employed as the transparent conductive layer forming bath liquid, a 500nm thick first transparent conductive layer 203 comprising zinc oxide was formed at a liquid temperature of 62°C and a cathode current density of 0.2A/cm².

For any of etching bath, first metal layer forming bath, second metal layer forming bath and transparent conductive layer forming bath, a solution stirring was performed by using the bath circulating apparatus shown in Fig. 3. The formed first transparent conductive layer 203 indicated a crystal structure of wurtzite type on the RHEED and presented crystal grains of 1 µm size in a SEM image. With other operations, conditions and design items similar to those of Example 4, first and second metal layers and a first transparent conductive layer were formed.

On the first transparent conductive layer 203 obtained in this way, a semiconductor layer 204 comprising a single pin structure containing silicon and germanium and a second transparent conductive layer 205 were formed by the CVD method similar to that of Example 4 and a photovoltaic device of the structure shown in Fig. 2 was obtained.

For the comparative study to this, except that a first metal layer comprising zinc, a second metal layer comprising copper and a transparent conductive layer comprising zinc oxide was formed on a stainless steel substrate by the sputtering method, a photovoltaic device of the structure shown in Fig. 2 was obtained in accordance with an operation and design similar to those described above.

On the photovoltaic device manufactured in Example 6 and the photovoltaic device with zinc, copper, zinc oxide, etc. deposited on a stainless steel substrate by the sputtering method, photoelectric conversion characteristic was examined by irradiating a simulator lamp. The measuring conditions were to be the same as with Example 1.

As a result, it was revealed that the photovoltaic device manufactured in Example 6 with first and second metal layers and a first transparent conductive layer formed using the aforesaid apparatus of Fig. 3 had 1.17 times the energy conversion efficiency for the photovoltaic device with zinc, copper and zinc oxide deposited on a stainless steel by the sputtering method. Thus, a photovoltaic device according to Example 6 was judged to have a large effect of light confinement.

Next, the aforesaid two types of photovoltaic devices was placed in a environmental test box of 85°C/85%RH and with the lapse of time, photoelectric conversion characteristic was monitored with 1V of reverse bias applied.

As a result, the photovoltaic device with copper and zinc oxide deposited on a stainless steel substrate by the sputtering method approached a shunt level of disabled state in 5 minutes and became unable to be used in 40 minutes. In contrast to this, the photovoltaic device manufactured in Example 6 with first and second metal layers and other layers formed using the apparatus shown in Fig. 3 could maintain a shunt level of usable state during a period of 11 hours.

By employing a method according to Example 3, the operating time and liquid temperature are free as compared with the manufacturing process using a substrate roll and the control of current becomes possible by a direct control of the cathode current. In addition, since various maintenances and inspections can be individually effected, a manufacturing process with a high degree of freedom can be constructed.

As described heretofore, the present invention provides a method for very inexpensively and stably manufacturing a photovoltaic device excellent in initial characteristics and long-term environmental stability and reliability.

A method for manufacturing a photovoltaic device comprising a metal layer, a first transparent conductive layer, a semiconductor layer and a second transparent conductive layer stacked on a substrate comprising iron in sequence, comprises the steps of forming the metal layer by deposition of a material constituting the metal layer from a solution and forming the first transparent conductive layer by deposition of a material constituting the first transparent conductive layer from a solution.

## Claims

1. A method for manufacturing a photovoltaic device comprising a metal layer, a first transparent conductive layer, a semiconductor layer and a second transparent conductive layer stacked on a substrate comprising iron in sequence, comprising the steps of:
forming said metal layer by deposition of a material constituting said metal layer from a solution; and
forming said first transparent conductive layer by deposition of a material constituting said first transparent conductive layer from another solution.

2. A method for manufacturing a photovoltaic device as set forth in Claim 1, wherein after etching said iron-containing substrate with an acidic solution, formation of said metal layer and formation of said first transparent conductive layer are performed on said substrate.

3. A method for manufacturing a photovoltaic device as set forth in Claim 1, wherein a layer comprising copper is formed as said metal layer.

4. A method for manufacturing a photovoltaic device as set forth in Claim 1, wherein a layer comprising zinc oxide is formed as said first transparent conductive layer.

5. A method for manufacturing a photovoltaic device as set forth in Claim 1, wherein a layer comprising copper is formed as said metal layer, and wherein a layer comprising zinc oxide is formed as said first transparent conductive layer.

6. A method for manufacturing a photovoltaic device as set forth in Claim 1, wherein in the step of forming said first transparent conductive layer, a material for said first transparent conductive layer is deposited from an acidic aqueous solution.

7. A method for manufacturing a photovoltaic device as set forth in Claim 3, wherein in the step of forming said metal layer, an aqueous solution containing copper ions, pyrophosphorate ions and nitrate ions is employed and the pH of said solution is adjusted to be 8.0-9.0.

8. A method for manufacturing a photovoltaic device as set forth in Claim 4, wherein in the step of forming said first transparent conductive layer, a solution containing zinc ions and nitrate ions is employed and the pH of said solution is adjusted to be 4.0-6.3.

9. A method for manufacturing a photovoltaic device as set forth in Claim 1, wherein the step of forming said metal layer and the step of forming said first transparent conductive layer are successively performed via a step of cleaning said substrate with water.

10. A method for manufacturing a photovoltaic device as set forth in Claim 1, wherein a belt-like substrate wound in the shape of a roll is used, wherein said substrate is delivered at one end, wherein the steps of forming said metal layer on said substrate and forming said first transparent conductive layer are successively performed via a step of cleaning said substrate with water, and wherein the substrate having passed through said steps is wound in at the other end.

11. A method for manufacturing a photovoltaic device as set forth in Claim 2, wherein the steps of etching said substrate with an acidic solution, forming said metal layer and forming said first transparent conductive layer are successively performed each via a step of cleaning said substrate with water.

12. A method for manufacturing a photovoltaic device as set forth in Claim 2, wherein with a belt-like substrate wound in the shape of a roll is used, wherein said substrate is delivered at one end, wherein the steps of etching said substrate with an acidic solution, forming said metal layer on said substrate and forming said first transparent conductive layer are successively performed each via a step of cleaning said substrate with water, and wherein said substrate having passed through said steps is wound in at the other end.

13. A method for manufacturing a photovoltaic device comprising a first metal layer, a second metal layer, a first transparent conductive layer, a semiconductor layer and a second transparent conductive layer stacked on a substrate comprising iron in sequence, comprising the steps of:
forming said first metal layer by deposition of a material constituting said first metal layer from a solution;
forming said second metal layer by deposition of a material constituting said second metal layer from a solution; and
forming said first transparent conductive layer by deposition of a material constituting said first transparent conductive layer from a solution.

14. A method for manufacturing a photovoltaic device as set forth in Claim 13, wherein after etching said iron-containing substrate with an acidic solution, formation of said first metal layer, formation of said second metal layer and formation of said first transparent conductive layer are performed on said subsrate.

15. A method for manufacturing a photovoltaic device as set forth in Claim 13, wherein a layer comprising zinc is formed as said first metal layer.

16. A method for manufacturing a photovoltaic device as set forth in Claim 13, wherein a layer comprising copper is formed as said second metal layer.

17. A method for manufacturing a photovoltaic device as set forth in Claim 13, wherein a layer comprising zinc oxide is formed as said first transparent conductive layer.

18. A method for manufacturing a photovoltaic device as set forth in Claim 13, wherein a layer comprising zinc is formed as said first metal layer, wherein a layer comprising copper is formed as said second metal layer, and wherein a layer comprising zinc oxide is formed as said first transparent conductive layer.

19. A method for manufacturing a photovoltaic device as set forth in Claim 13, wherein in the step of forming said first transparent conductive layer, a material for said first transparent conductive layer is deposited from an acidic aqueous solution.

20. A method for manufacturing a photovoltaic device as set forth in Claim 15, wherein in the step of forming said first metal layer, an aqueous solution containing sulfate ions and zinc ions is employed and the pH of said solution is adjusted to be 1.5-4.5.

21. A method for manufacturing a photovoltaic device as set forth in Claim 15, wherein in the step of forming said first metal layer, an aqueous solution containing chlorine ions and zinc ions is employed and the pH of said solution is adjusted to be 4.0-7.0.

22. A method for manufacturing a photovoltaic device as set forth in Claim 16, wherein in the step of forming said second metal layer, an aqueous solution containing sulfate ions and copper ions is employed.

23. A method for manufacturing a photovoltaic device as set forth in Claim 17, wherein in the step of forming said first transparent conductive layer, the pH of an aqueous solution containing zinc ions and nitrate ions is adjusted to be 4.0-6.3.

24. A method for manufacturing a photovoltaic device as set forth in Claim 13, wherein the steps of forming said first metal layer, forming said second metal layer, and forming said first transparent conductive layer are successively performed each via a step of cleaning said substrate with water.

25. A method for manufacturing a photovoltaic device as set forth in Claim 13, wherein a belt-like substrate wound in the shape of a roll is used, wherein said substrate is delivered at one end, wherein the steps of forming said first metal layer on said substrate, forming said second metal layer, and forming said first transparent conductive layer are successively performed each via a step of cleaning said substrate, and wherein said substrate having passed through said steps is wound in at the other end.

26. A method for manufacturing a photovoltaic device as set forth in Claim 14, wherein the steps of etching said substrate with an acidic solution, forming said first metal layer, forming said second metal layer and forming said first transparent conductive layer are successively performed each via a step of cleaning said substrate with water.

27. A method for manufacturing a photovoltaic device as set forth in Claim 14, wherein a belt-like substrate wound in the shape of a roll is used, wherein said substrate is delivered at one end, wherein the steps of etching said substrate with an acidic solution, forming said first metal layer on said substrate, forming said second metal layer, and said first transparent conductive layer are successively performed each via a step of cleaning said substrate with water and wherein said substrate having passed through said steps is wound in at the other end.

28. A photovoltaic device comprising a metal layer formed by plating, a first transparent conductive layer formed by plating, a semiconductor layer, and a second transparent conductive layer, stacked on a substrate comprising iron, in sequence.

29. A photovoltaic device as set forth in Claim 28, wherein said metal layer comprises copper.

30. A photovoltaic device as set forth in Claim 28, wherein said first transparent conductive layer comprises zinc oxide.

31. A photovoltaic device comprising a first metal layer formed by plating, a second metal layer formed by plating, a first transparent conductive layer formed by plating, a semiconductor layer and a second transparent conductive layer stacked on a substrate comprising iron, in sequence.

32. A photovoltaic device as set forth in Claim 31, wherein said first metal layer comprises zinc.

33. A photovoltaic device as set forth in Claim 31, wherein said second metal layer comprises copper.

34. A photovoltaic device as set forth in Claim 31, wherein said first transparent conductive layer comprises zinc oxide.
